Europäisches Patentamt

European Patent Office

Office européen des brevets

(11) Numéro de publication : **0 045 676**
**B1**

(12) **FASCICULE DE BREVET EUROPÉEN**

(45) Date de publication du fascicule du brevet :
26.10.83

(51) Int. Cl.³ : **H 01 L 31/18, H 01 L 31/06**

(21) Numéro de dépôt : **81401156.5**

(22) Date de dépôt : **21.07.81**

(54) Procédé de réalisation d'une couche en silicium amorphe, et dispositif électronique mettant en œuvre ce procédé.

(30) Priorité : **25.07.80 FR 8016492**

(43) Date de publication de la demande :
**10.02.82 Bulletin 82/06**

(45) Mention de la délivrance du brevet :
**26.10.83 Bulletin 83/43**

(84) Etats contractants désignés :
**DE IT NL**

(56) Documents cités :
**DE A 2 743 141**

**JOURNAL OF THE ELECTROCHEMICAL SOCIETY, vol. 126, no. 4, avril 1979 Princeton N.J. US D.E. CARLSON et al. : « The effect of hydrogen content on the photovoltaic properties of amorphous silicon », pages 688-691**

**IBM TECHNICAL DISCLOSURE BULLETIN, vol. 22, no. 8b janvier 1980, New York, US J.L. FREEOUF : « Chemical hydrogenation of amorphous silicon », page 3864**

(73) Titulaire : **THOMSON-CSF**
**173, Boulevard Haussmann**
**F-75379 Paris Cedex 08 (FR)**

(72) Inventeur : **Dieumegard, Dominique**
**THOMSON-CSF SCPI-173, bld Haussmann**
**F-75360 Paris Cedex 08 (FR)**
Inventeur : **Friederich, Alain**
**THOMSON-CSF SCPI-173, bld Haussmann**
**F-75360 Paris Cedex 08 (FR)**

(74) Mandataire : **Lepercque, Jean et al**
**THOMSON-CSF SCPI 173, Bld Haussmann**
**F-75379 Paris Cedex 08 (FR)**

Procédé de réalisation d'une couche en silicium amorphe, et dispositif électronique mettant en œuvre ce procédé

La présente invention concerne un procédé de réalisation de dispositifs semiconducteurs comprenant une couche de silicium amorphe hydrogéné. L'invention s'applique notamment à la fabrication de dispositifs de conversion photoélectrique tels que les cellules photovoltaïques.

Ces dispositifs semiconducteurs possèdent généralement une structure multicouche, comprenant au moins une jonction p-n ou un contact métal-semiconducteur. On utilise le plus souvent comme matériau semiconducteur de base le silicium. Les couches de matériau semiconducteur sont réalisées par les techniques dites de dépôt en couche mince sur un substrat assurant notamment la tenue mécanique du dispositif.

Lorsqu'on dépose, par tout procédé connu, une couche mince de silicium sur un substrat non cristallin, tel que du verre de silice, on n'obtient pas une couche monocristalline mais une couche ayant une structure polycristalline ou amorphe, selon les conditions de dépôt et notamment selon la température sous laquelle s'effectue ce dépôt.

Sous la forme polycristalline, le silicium absorbe peu la lumière, si bien que l'épaisseur minimale de la couche à déposer pour obtenir un rendement suffisant est de l'ordre de plusieurs dizaines de microns. Or un des facteurs limitant le plus la fabrication de dispositifs de type photovoltaïque est leur prix de revient. Pour réduire le coût, il est donc souhaitable d'utiliser des couches les plus minces possibles, de l'ordre du micronmètre. Pour cela, il a été proposé d'utiliser le silicium sous forme amorphe dont l'absorption optique est nettement supérieure à celle du silicium cristallin.

Cependant, le silicium amorphe présente en général des caractéristiques de conductivité électrique moins bonnes que le silicium cristallin, ceci est dû notamment à l'existence de liaisons chimiques brisées. Pour améliorer la qualité du silicium amorphe, des procédés d'hydrogénation des couches déposées ont notamment été proposés.

Un premier procédé consiste en la décomposition plasma de silane (SiH4) ou la pulvérisation cathodique de silicium en atmosphère réactive d'hydrogène. La mise en œuvre de ce procédé conduit généralement à des incorporations d'hydrogène de l'ordre de 10 à 30 % en concentration atomique par rapport au silicium, soit une quantité beaucoup plus grande que celle nécessaire pour saturer les liaisons brisées du silicium amorphe dont la concentration est en générale voisine de 0,1 %.

Un second procédé est décrit dans la demande de brevet français n° 77 17 245, déposée le 6 juin 1977 et publiée sous le n° 2 394 173. Cette demande de brevet concerne un procédé de fabrication de dispositifs comportant une couche de silicium amorphe permettant d'améliorer les propriétés électriques de la couche. Ce procédé consiste à déposer la couche de silicium amorphe par évaporation, pulvérisation sous vide ou à pression réduite, à basse température (de l'ordre de 600 °C), puis à effectuer un traitement thermique de la couche déposée dans un plasma d'hydrogène ou de l'un de ses isotopes toujours à une température assez basse pour que le silicium ne cristallise pas, mais suffisante pour que l'hydrogène diffuse dans la couche de silicium amorphe. Cette technique d'hydrogénation, appliquée à du silicium amorphe, permet de contrôler la proportion d'hydrogène contenue dans le matériau. Les avantages recueillis résident principalement dans la flexibilité du mode de préparation.

Ce procédé d'hydrogénation sous plasma d'hydrogène ou de l'un de ces isotopes conduit à l'obtention de profils de concentration en hydrogène non homogène. Il s'agit de profils classiques de diffusion dont la concentration en surface varie de 1 à 10 % selon la densité du plasma et le mode opératoire. L'incorporation d'hydrogène dans la couche de silicium amorphe est d'autant plus grande que le plasma est dense, mais en contrepartie, l'augmentation de densité conduit toujours à une attaque chimique de la couche de silicium amorphe ce qui limite la durée du traitement et ne permet pas d'étendre les profils de diffusion au-delà de 0,3 µm en profondeur. L'utilisation de plasma peu dense réduit l'attaque chimique mais nécessite des traitements très longs (quelques heures) pour assurer l'extension du profil de diffusion et peut ne pas permettre des incorporations d'hydrogène suffisantes pour certaines applications.

Tout au contraire l'invention propose un procédé de fabrication de couches de silicium amorphe permettant une hydrogénation dans de bonnes conditions, tout en obviant les inconvénients de l'art connu qui viennent d'être rappelés.

L'invention a donc pour objet un procédé de réalisation d'une couche en silicium amorphe hydrogéné comprenant une étape de dépôt de la couche de silicium amorphe sur un support caractérisé en ce qu'il comprend en outre les étapes successives suivantes :

a) mise en place d'une pellicule de métal sur ladite couche en silicium amorphe, le métal étant sélectionné parmi ceux qui présentent une grande affinité pour l'hydrogène sous forme atomique et la pellicule de métal ayant une épaisseur minimale de 0,5 nm ;

b) hydrogénation de la pellicule de métal ;

c) traitement thermique compris entre 100 °C et la température de cristallisation du silicium et résultant dans la diffusion de l'hydrogène dans la couche en silicium amorphe à partir de la pellicule de métal agissant alors comme source d'hydrogène atomique.

L'invention a aussi pour objet un procédé de réalisation d'une couche en silicium amorphe hydrogéné comprenant une étape de dépôt de la couche de silicium amorphe sur un support caractérisé en ce qu'il comprend en outre les étapes successives suivantes :

a) mise en place d'une pellicule de métal sur ladite couche en silicium amorphe, le métal étant sélectionné parmi ceux qui présentent une grande affinité pour l'hydrogène sous forme atomique et la pellicule de métal ayant une épaisseur minimale de 0,5 nm et une épaisseur maximale inférieure à 100 nm ;

b) exposition de la couche de métal à un plasma d'hydrogène ou à l'un de ses isotopes et traitement thermique à une température comprise entre 100 °C et la température de cristallisation du silicium résultant dans la diffusion de l'hydrogène venant du plasma dans le silicium amorphe.

L'invention a également pour objet un dispositif selon les revendications 14 et 15 comprenant au moins une couche de silicium amorphe obtenue par ce procédé.

L'invention sera mieux comprise et d'autres caractéristiques et avantages apparaîtront à la lecture de la description ci-après et des figures annexées parmi lesquelles :

la figure 1 représente schématiquement un appareillage permettant le dépôt de couches selon l'invention ;

la figure 2 décrit l'étape d'hydrogénation d'une couche de silicium amorphe traitée selon l'invention, selon une variante d'exécution ;

la figure 3 décrit la même étape, selon une autre variante d'exécution ;

la figure 4 décrit un dispositif comprenant une couche de silicium amorphe obtenue par le procédé de l'invention.

Le dépôt proprement dit en couche mince de silicium amorphe sur un substrat est réalisé par tous procédés convenables de l'art connu. Un exemple d'un tel procédé va être décrit dans ce qui suit à titre d'illustration non limitative.

Suite à ce dépôt le procédé de l'invention comprend dans tous les cas une étape consistant en la mise en place en au moins des endroits déterminés de la surface de la couche déposée d'une mince pellicule de métal. L'épaisseur de cette pellicule est de l'ordre de 100 Å. Cette épaisseur peut cependant être variable pour des raisons qui seront discutées ultérieurement.

Ensuite la couche de silicium amorphe recouverte de la pellicule métallique va être hydrogénée. Cette hydrogénation peut s'effectuer selon plusieurs variantes qui vont également être discutées dans ce qui suit. Dans tous les cas la pellicule de métal joue un premier rôle de filtrage des protons d'hydrogène. Le métal est choisi parmi les métaux qui ont une grande affinité pour l'hydrogène sous forme atomique. On peut citer le palladium (Pd), le platine (Pt), le nickel (Ni) et le fer (Fe). Cete affinité s'accompagne d'un coefficient de diffusion important (D $\#$ $10^{-6}$ cm$^2$/s à température ambiante). Cette propriété va permettre l'hydrogénation de la couche de silicium amorphe sous-jacente dans de bonnes conditions.

Enfin, dans une des variantes d'hydrogénation qui va être discutée ultérieurement, la pellicule métallique joue un rôle supplémentaire de protection de la couche de silicium pendant l'étape d'hydrogénation.

Avant de décrire plus en détail le procédé de l'invention, il paraît utile de décrire brièvement, à titre d'illustration, un procédé et un appareil de l'art connu permettant d'obtenir, dans une étape préliminaire, le dépôt d'une couche de silicium amorphe sur un substrat.

Un procédé possible de réalisation d'une couche semiconductrice contenant du silicium comprend une étape de dépôt par décomposition thermique d'un mélange gazeux.

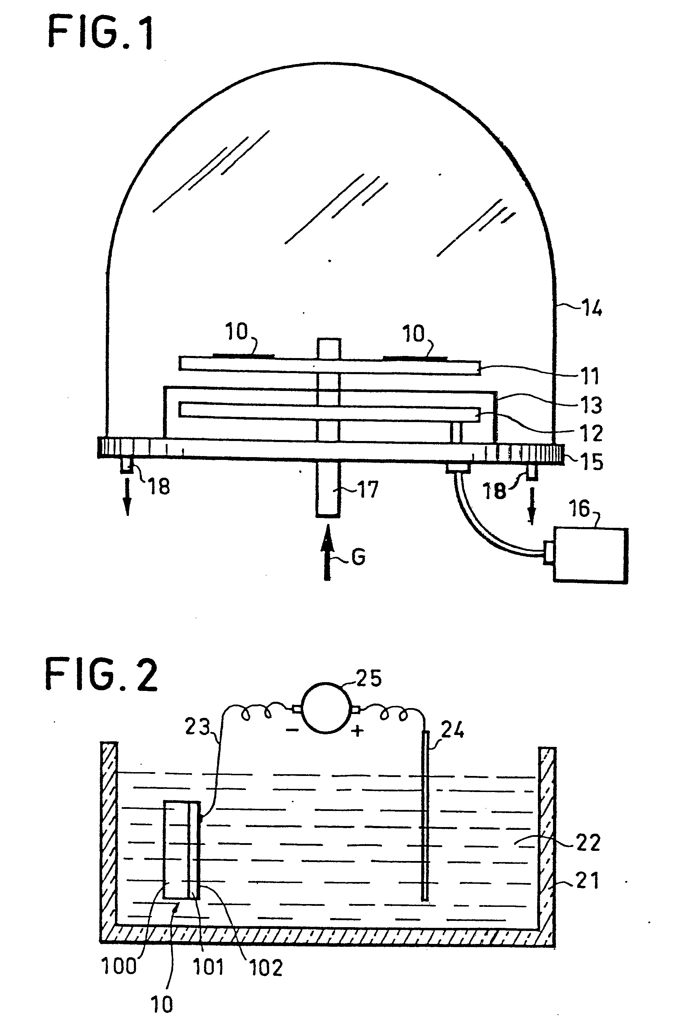

Un appareillage permettant ce dépôt va tout d'abord être décrit en relation avec la figure 1. Sur la figure 1 est représenté schématiquement un réacteur comprenant une chambre de réaction verticale et composée des éléments suivants :

— un support circulaire 11 en graphite recouvert de carbure de silicium reposant sur un piédestal en quartz (non représenté sur la figure). L'ensemble support et piédestal est animé d'un mouvement de rotation, réglable typiquement entre 0 et 30 tours par minute ;

— un bobinage comprenant une self spiralée 12, situé dans un plan parallèle au support 11 et couplé inductivement à celui-ci. La self est reliée à un générateur haute fréquence 16 fonctionnant à 400 KHz et de puissance 25 KW.

— une jupe en quartz 13 isolant la self de la chambre de réaction ;

— une cloche en quartz 14 posée sur un socle également en quartz 15. L'ensemble délimite le volume de la chambre de réaction.

— un injecteur 17 situé au centre de suscepteur permet l'introduction des gaz G à décomposer dans la chambre à réaction, ces gaz étant évacués par le bas du réacteur par les orifices 18.

Les débits gazeux sont mesurés de façon classique à l'aide de tubes débitmètres à bille munis de robinets à soufflet en acier inoxydable. Sur le support 11 sont représentés, sous la référence 10, des dispositifs en cours de réalisation c'est-à-dire des dispositifs comprenant au moins un substrat sur lequel doit être déposée une couche de silicium amorphe. La cloche 14 peut comporter également des fenêtres de visée permettant la mesure de la température de ces dispositifs 10 à l'aide de dispositifs de mesure à infrarouge. Toutes ces dispositions sont bien connues de l'homme de métier.

La méthode retenue pour le dépôt est également connue en soi. Il s'agit de dépôt en phase gazeuse sous pression atmosphérique. La méthode consiste en une décomposition thermique du silane (SiH$_4$) qui est la source de silicium. Le silane est mélangé à de l'argon ou de l'hydrogène, ce dernier gaz donnant de meilleurs résultats, dans une proportion volumique de 90 % pour l'hydrogène ou l'argon et de 10 % pour le silane. Le mélange peut comprendre un troisième gaz fournissant le dopant, par exemple l'arsine pour l'arsenic, le diborane pour le bore ou la phosphine pour le phosphore. La proportion de ce dernier gaz par rapport au silane doit être réglée de façon très précise suivant le degré de dopage désiré. Cette proportion peut varier typiquement de $10^{-6}$ à $10^{-3}$ molécules de gaz dopant pour une molécule de silane. Le substrat sur lequel est déposée la couche contenant du silicium dépend de la structure du dispositif électronique à réaliser. Il peut s'agir par exemple d'une plaque de silice fondue ou de silicium monocristallin. Le traitement préliminaire de ces substrats sort du cadre de l'invention et ne sera pas décrit. Le dépôt croît à une vitesse d'environ 1 μm par heure. La température de dépôt est de l'ordre de 600 °C.

Le procédé de dépôt qui vient d'être rappelé n'est pas limitatif des procédés utilisables pour obtenir une couche de silicium amorphe. On peut notamment mettre en œuvre les procédés de dépôts en phase vapeur (appelés couramment « C.V.D. » selon l'expression anglo-saxonne « chemical vapor deposition ») ainsi que le procédé de pulvérisation. D'autre part les autres hydrures de silicium sont également utiisables à la place du silane.

Le procédé de l'invention, dans ses différentes variantes d'exécution va maintenant être décrit de façon plus détaillée.

Une première étape, commune à toutes les variantes, consiste comme il a été déjà mentionné, en la mise en place d'une pellicule métallique superficielle. Cette mise en place peut s'effectuer de façon préférentielle par évaporation sous vide poussé (de l'ordre de $10^{-6}$ Pa), évaporation obtenue par bombardement électronique du métal à déposer sur la couche de silicium amorphe. Ce procédé est bien connu de l'homme de métier et il n'y a pas lieu de le décrire plus avant. D'autres procédés connus, telle que la pulvérisation cathodique de métal, sont également utilisables. L'important est que le procédé choisi permette un dépôt d'une pellicule de métal compacte sans trous. Ces trous permettraient, dans certaines variantes de réalisation du procédé de l'invention, une attaque de la couche de silicium amorphe et sa dégradation.

Cette étape de mise en place d'une pellicule métallique, est ensuite suivie d'une étape d'hydrogénation permettant de passiver les liaisons brisées de la couche de silicium amorphe. Cette hydrogénation peut s'effectuer selon trois variantes.

Selon une première variante, l'hydrogénation s'effectue simplement en mettant le dispositif comprenant la couche de silicium amorphe recouverte de sa pellicule métallique en présence d'hydrogène sous forme moléculaire. Ceci peut être réalisé simplement par introduction d'hydrogène dans la cloche 4 de l'appareil décrit en relation avec la figure 1 ou encore plus simplement en exposant le dispositif à l'air libre, cette dernière méthode étant cependant moins efficace.

L'hydrogène moléculaire en présence des métaux précités se dissocie sous forme de protons. L'un des cas les plus favorables est celui du palladium dans lequel des concentrations atomiques (H/Pb) de l'ordre de 0,6 peuvent être obtenues à température ambiante et pression atmosphérique de l'hydrogène. Les protons diffusent alors dans le Palladium par simple agitation thermique vers la couche de silicium amorphe. Par traitement thermique ultérieur, vers 400 °C (température à laquelle le coefficient de diffusion de l'hydrogène dans le silicium amorphe est d'un ordre de grandeur convenable) la couche mince de palladium riche en hydrogène constitue alors une source d'hydrogène permettant sa diffusion dans le silicium amorphe.

Pour ce faire, il suffit de chauffer le dispositif comprenant la couche de silicium amorphe recouverte de la couche de métal à la température désirée. L'efficacité de passivation des liaisons brisées du silicium amorphe de l'ordre de 30 % pour une couche de 1 μm d'épaisseur. La concentration en liaisons brisées résiduelles peut être mesurée par mise en œuvre de la méthode dite de « Résonance Paramagnétique électronique » (R.P.E.).

Selon une seconde variante, l'hydrogénation s'effectue par électrolyse. En effet la couche mince métallique peut être « chargée » en hydrogène par électrolyse. Utilisée comme cathode dans un bain d'électrolyse, par exemple dans de l'acide sulfurique dilué ($H_2SO_4$), des concentrations atomiques (H/Pb) voisines de l'unité peuvent être atteintes en une fraction de minute. La concentration d'acide sulfurique peut être de l'ordre de 10 %. On augmente ainsi fortement la densité de protons dans la pellicule métallique qui peut être, comme dans le cas de la première variante, utilisée comme source de protons pour la diffusion ultérieure à 400 °C dans la couche de silicium amorphe. Des expériences ont montré que cette méthode permettait de saturer deux tiers des liaisons brisées du silicium amorphe. Cette proportion est mesurée par mise en œuvre de la méthode précédemment mentionnée (R.P.E.).

La figure 2 illustre schématiquement l'étape d'hydrogénation selon cette variante de réalisation du procédé de l'invention. Une cuve d'électrolyse 21 contient une solution acide 22. Le dispositif 10 comprend un substrat 100 sur lequel a été déposée une couche de siicium amorphe 101 recouverte d'une mince pellicule de métal 102. La borne négative d'un générateur de tension continue 25 est reliée à la couche métallique 102 par une connexion électrique qui peut y être soudée, la couche métallique 102 jouant le rôle de cathode. La borne positive du générateur est reliée à une anode 24. Dans cette variante les différents éléments constitutifs du dispositif 10 ne doivent pas être attaqués par la solution acide 22.

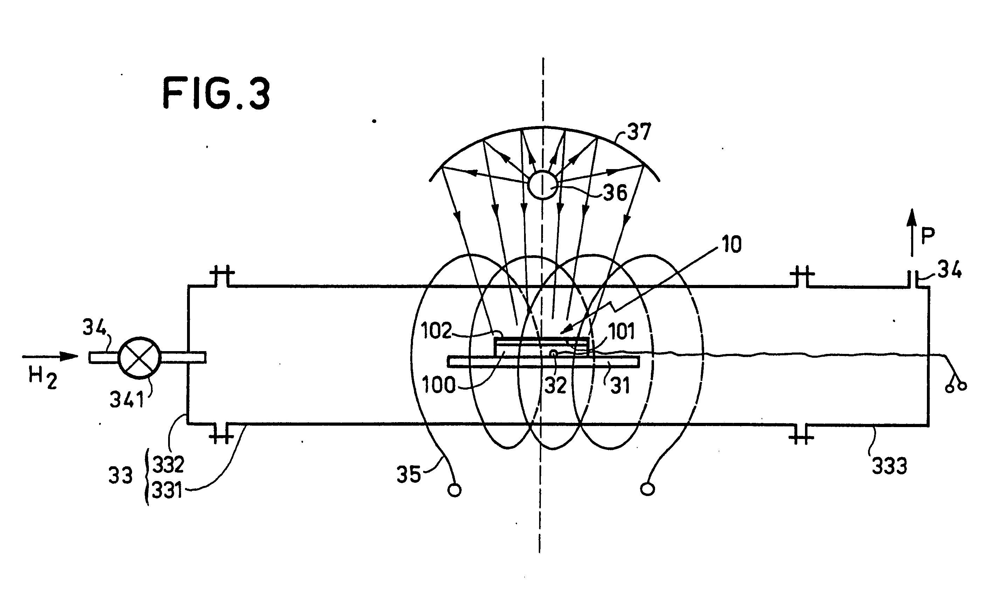

Selon une troisième variante de réalisation du procédé de l'invention, l'hydrogénation s'effectue sous plasma d'hydrogène et, par exemple, par la mise en œuvre du procédé décrit dans la demande de brevet français n° 77 17 245 précitée et qui va être rappelé brièvement dans ce qui suit, en décrivant à l'aide de la figure 3, un exemple d'appareillage permettant sa mise en œuvre.

La figure 3 représente en effet schématiquement un appareillage permettant d'effectuer l'hydrogénation du silicium amorphe dans une atmosphère de plasma d'hydrogène.

Les moyens représentés sur la figure 3 comprennent :

— une plaque 31 de molybdène ou de silice fondue, qui est utilisée comme support d'un dispositif 10 comprenant un substrat 100 portant une couche 101 de silicium amorphe recouverte de sa couche métallique 102.

— un thermocouple 32 que l'on dispose sur le support 31 au voisinage immédiat de la couche 101. Ce thermocouple est destiné à contrôler la température pendant le traitement.

— une enceinte 33 constituée par exemple par un tube 331 en silice fondue, fermé aux extrémités par les embouts 332 et 333 traversé par un tube 34 de plus faible diamètre que le tube 331. Ce tube est destiné à faire circuler un courant d'hydrogène H$_2$ dans l'enceinte. Il est muni d'une vanne 341 à une extrémité. A l'autre extrémité du tube 33 est disposée une canalisation 38 de raccordement à une pompe à vide représentée symboliquement par une flèche marquée P, cette pompe est capable de maintenir la pression d'hydrogène au-dessous de 10 Pa environ pour un débit de l'ordre d'une fraction de litre par minute.

— un enroulement 35 de fil conducteur alimenté en courant électrique de haute fréquence, capable de créer un plasma dans la région de l'enceinte 33 dans laquelle est placé le dispositif 10.

— et un système de chauffage par radiation comportant une source 36 et un réflecteur 37 capable de réfléchir de façon sensiblement uniforme les radiations produites par la source 36 sur une surface de l'ordre de celle de la couche de silicium amorphe à traiter.

La pellicule métallique 102 est transparente à la diffusion de l'hydrogène venant du plasma. Le traitement d'hydrogénation est effectué sous une température de l'ordre de 450 à 500 °C et sous une pression d'hydrogène de 10 Pa, pendant une durée de traitement pouvant aller jusqu'à une heure. Dans ces conditions l'extension du profil de diffusion est assurée jusqu'à 0,5 µm en profondeur ou plus. La couche mince est en platine et celui-ci se transforme en siliciure de platine (PtSi) qui reste stable pendant la durée du traitement. A la place de l'hydrogène, on peut utiliser également l'un de ses isotopes.

Dans certaines applications, il peut être intéressant de transformer le platine en siliciure de platine avant d'exposer celui-ci au plasma d'hydrogène, notamment pour assurer une transformation plus complète de la pellicule lorsque celle-ci est épaisse. Pour ce faire divers procédés connus peuvent être utilisés et parmi ceux-ci :

— le recuit sous hydrogène moléculaire, éventuellement à une température différente du traitement thermique pendant lequel le dispositif est exposé au plasma d'hydrogène.

— l'implantation ionique directe de platine dans le silicium amorphe

— ou le bombardement ionique de gaz rare selon la technique de formation de composés métalliques par implantation recul de platine.

Cette technique, d'autre part, peut être mise en œuvre dans le cadre des deux premières variantes décrites.

L'inconvénient majeur des traitements sous plasma de l'art connu, qui a été rappelé dans le préambule de la présente description, consiste en l'attaque chimique du silicium amorphe. Cette attaque chimique est d'autant plus forte que le plasma est dense ou que le traitement est de longue durée.

En plasma dense, elle est de plusieurs centaines d'Angstroem par minute, en plasma moins dense la vitesse d'attaque v est plus faible (typiquement v # 10 Å/mn) mais la recherche d'une hydrogénation efficace du silicium amorphe nécessite à la fois d'augmenter la densité du plasma et la durée du traitement (quelques heures). Dans ces conditions, une attaque chimique de la surface est toujours présente.

Grâce au procédé de l'invention, dont la caractéristique essentielle est la mise en place d'une couche mince de métal sur le silicium amorphe, cette attaque est évitée. La couche de métal 102 joue alors dans la variante qui vient d'être décrite un rôle supplémentaire de protection. Cette variante du procédé de l'invention constitue également la variante de réalisation préférée, car elle permet des traitements de diffusion beaucoup plus efficaces puisque des fortes densités de plasma peuvent être utilisées. Ces conditions assurent une extension plus importante du profil de diffusion de l'hydrogène dans la couche sans que cette dernière soit détériorée par le plasma, ainsi qu'une hydrogénation plus efficace. L'efficacité est pratiquement égale à 100 %.

Un autre avantage de cette variante de réalisation est de permettre une hydrogénation sélective de la couche de silicium amorphe éventuellement combinée avec une attaque également sélective de certaines régions de cette couche.

En effet, il a été supposé implicitement dans ce qui précède que la pellicule métallique 102 avait une épaisseur uniforme sur toute la surface de la couche de silicium 101, mais il peut en être autrement et cette épaisseur joue un rôle essentiel vis-à-vis de l'attaque chimique de la couche de silicium amorphe et de son hydrogénation.

En mettant en œuvre une technologie du type « planar », associée aux techniques habituelles de masquage, pour réaliser le dépôt de métal sur la couche de silicium amorphe, on peut délimiter des zones distinctes sur la surface de la couche de silicium amorphe. Ces zones peuvent être divisées en trois classes principales :

— zones sur lesquelles il n'y a pas eu de dépôt de métal : dans ce cas l'attaque chimique de la couche de silicium amorphe peut être complète si la densité du plasma et/ou le temps d'attaque est suffisant.

— zones sur lesquelles, il y a eu dépôt d'une couche mince de métal d'épaisseur e, typiquement dans une gamme : 50 Å ≤ e ≤ 100 Å. Dans ce cas l'attaque de la couche de silicium amorphe est évitée, mais l'hydrogénation, comme il a été décrit précédemment, s'effectue dans de très bonnes conditions.

— et des zones sur lesquelles une couche épaisse a été déposée, l'épaisseur de cette couche est typiquement supérieure à 1 000 Å. Dans ce cas il n'y a ni attaque, ni hydrogénation de la couche de silicium.

Par ce procédé on peut réaliser des dispositifs électroniques possédant des régions de nature et de propriétés physiques et électriques différentes. A titre d'illustration, on peut déposer sur un substrat deux couches de silicium amorphes superposées et différemment dopées. On peut donc créer des jonctions, par exemple de type p n, aux seuls endroits où la couche supérieure n'a pas été attaquée par le plasma. D'autre part, à l'interface semiconducteur-métal, il y a création d'une jonction de type Schottky et, selon l'épaisseur de métal déposée sur la couche de silicium amorphe, épaisseur qui autorise une hydrogénation plus ou moins importante ou pas d'hydrogénation (e ≥ 1 000 Å), la conductivité des régions sous-jacentes sera variable.

Enfin, il est à noter que si le métal utilisé est du platine, comme il a été rappelé, il se forme pendant l'étape d'hydrogénation du siliciure de platine (PtSi). Ce siliciure de platine est très transparent au rayonnement solaire, d'une grande stabilité chimique et bon conducteur électrique. Il s'en suit que les dispositifs semiconducteurs réalisés selon le procédé de l'invention et notamment suivant la troisième variante qui procure la meilleure qualité d'hydrogénation de la couche de silicium amorphe, ce associé à la disposition supplémentaire qui consiste à choisir de préférence le platine, sont particulièrement bien adaptés pour les applications de conversion photoélectriques.

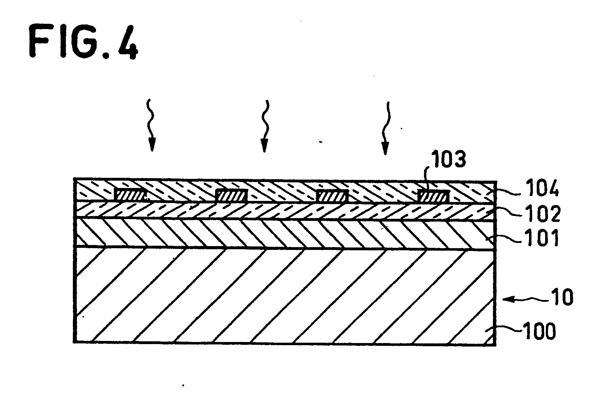

Un exemple d'une telle réalisation va maintenant être décrit en relation avec la figure 4, qui représente de façon schématique une pile solaire du type comportant une jonction métal-silicium. La pile solaire 10 comprend un substrat métallique 100 assurant la rigidité mécanique de l'ensemble. On peut citer comme matériaux types l'aluminium, le chrome, l'acier inoxydable ou le fer. Sur la surface supérieure du substrat métallique 100 est déposée une couche contenant du silicium amorphe 101. Cette couche peut avoir une épaisseur de l'ordre de 0,5 à 1 μm. Des impuretés de type n ont été introduites dans une proportion déterminée, ce en incorporant de la phosphine par exemple au gaz introduit dans le réacteur de la figure 1. La couche 101 en silicium amorphe est ensuite recouverte d'une mince couche métallique 102 selon le procédé de l'invention, par exemple du platine, cette couche restant du fait de sa minceur (typiquement 50 Å à 100 Å) transparente aux rayons solaires auxquels doit être exposée la couche 101. En outre s'il s'agit de platine, il se forme, comme il a été rappelé du siliciure de platine pendant l'étape d'hydrogénation, ce qui améliore encore les qualités optiques de la couche 102. L'interface entre les couches 101 et 102 forme une jonction de type Schottky. Les photons traversent la couche métallique 102 pratiquement sans être absorbés. Ils sont par contre absorbés par la couche de silicium amorphe 101 qui peut avoir un coefficient d'absorption de l'ordre de $5 \cdot 10^4$ cm$^{-1}$ pour une longueur d'onde égale à 0,6 μm, si bien que, pour une épaisseur de la couche 101 de l'ordre de 1 μm, la proportion de rayonnement absorbée est peu différente de l'unité. Les photons absorbés génèrent des paires électrons-trous qui sont dissociées dans la couche 101, libérant ainsi des électrons pouvant circuler vers la couche 102. Le dispositif de la figure 4 est complété par l'adjonction d'une grille métallique 103 formant électrode, réalisée en métal de bonne conductivité électrique. La grille peut être constituée, par exemple, de deux séries de fils parallèles, les fils de la première série étant disposés suivant une direction orthogonale à la direction des fils de la seconde série. La surface occupée par cette électrode peut être réduite au minimum et être par exemple de l'ordre de 5 à 10 % de la surface utile du dispositif. Cette grille formant électrode a pour but de recueillir de façon uniforme le courant circulant dans la couche 102, ce sous faible résistance électrique. Enfin une couche superficielle antiréfléchissante 104 est disposée sur la couche 102 englobant la grille formant électrode 103. Comme il est bien connu l'épaisseur e de cette couche est reliée à la longueur d'onde par la relation suivante :

$$e = \lambda/4n$$

relation dans laquelle λ est la longueur d'onde de la radiation lumineuse à convertir et n est l'indice de réfraction optique de la couche 104. Dans le cas d'un spectre étendu une valeur de longueur d'onde moyenne sera sélectionnée. Lorsque le dispositif est éclairé on peut obtenir un courant électrique proportionnel à l'éclairement en reliant la grille formant électrode 103, d'une part, et le substrat 100 conducteur, d'autre part, à un circuit de charge extérieure non représenté.

## Revendications

1. Procédé de réalisation d'une couche en silicium amorphe hydrogéné (101) comprenant une étape de dépôt de la couche de silicium amorphe sur un support (100) caractérisé en ce qu'il comprend en outre les étapes successives suivantes :

a) mise en place d'une pellicule de métal (102) sur ladite couche en silicium amorphe (101), le métal étant sélectionné parmi ceux qui présentent une grande affinité pour l'hydrogène sous forme atomique et la pellicule de métal ayant une épaisseur minimale de 0,5 nm ;

b) hydrogénation de la pellicule de métal (102) ;

c) traitement thermique compris entre 100 °C et la température de cristallisation du silicium et résultant dans la diffusion de l'hydrogène dans la couche en silicium amorphe à partir de la pellicule de métal agissant alors comme source d'hydrogène atomique.

2. Procédé selon la revendication 1 caractérisé en ce que l'étape d'hydrogénation de la pellicule de métal (102) est réalisée par son exposition à une atmosphère constituée d'hydrogène moléculaire pendant un temps déterminé.

3. Procédé selon la revendication 1 caractérisé en ce que l'étape d'hydrogénation de la pellicule de métal (102) est réalisée par électrolyse dans une solution acide (22).

4. Procédé selon la revendication 3 caractérisé en ce que la solution acide (22) est une solution d'acide sulfurique dilué,

5. Procédé de réalisation d'une couche en silicium amorphe hydrogéné (101) comprenant une étape de dépôt de la couche de silicium amorphe sur un support (100) caractérisé en ce qu'il comprend en outre les étapes successives suivantes :

a) mise en place d'une pellicule de métal (102) sur ladite couche en silicium amorphe (101), le métal étant sélectionné parmi ceux qui présentent une grande affinité pour l'hydrogène sous forme atomique et la pellicule de métal ayant une épaisseur minimale de 0,5 nm et une épaisseur maximale inférieure à 100 nm ;

b) exposition de la couche de métal (102) à un plasma d'hydrogène ou à l'un de ses isotopes et traitement thermique à une température comprise entre 100 °C et la température de cristallisation du silicium résultant dans la diffusion de l'hydrogène venant du plasma dans le silicium amorphe.

6. Procédé selon la revendication 5 caractérisé en ce que l'étape de traitement thermique et d'exposition de la pellicule de métal (102) à un plasma d'hydrogène est conduite dans une atmosphère contenant de l'hydrogène sous une pression de l'ordre de 100 Pa et à une température de l'ordre de 450 °C.

7. Procédé selon l'une quelconque des revendications 5 ou 6 caractérisé en ce que en outre pendant la première étape la pellicule de métal est mise en place de façon non uniforme sur la couche de silicium amorphe (101), l'épaisseur de la pellicule de métal (102) variant suivant un programme prédéterminé, divisant la surface de la couche de silicium amorphe (101) en au moins deux zones distinctes.

8. Procédé selon la revendication 7 caractérisé en ce que la surface de la couche de silicium amorphe (101) comporte au moins trois zones distinctes et en ce que sur la première zone aucun métal n'a été disposé, sur la seconde zone l'épaisseur e du métal est comprise dans la gamme : 0,5 nm ≤ e ≤ 10 nm et sur la troisième zone le métal a une épaisseur e supérieure à 100 nm.

9. Procédé selon l'une quelconque des revendications 1 à 6 caractérisé en ce que l'épaisseur de la pellicule de métal (102) e est comprise dans la gamme : 0,5 nm ≤ e ≤ 10 nm et en ce que celle-ci a une épaisseur constante et recouvre toute la surface de la couche de silicium amorphe (101).

10. Procédé selon l'une quelconque des revendications 1 à 9 caractérisé en ce que le métal est choisi parmi les métaux suivants : Palladium, Platine, Nickel ou Fer.

11. Procédé selon l'une quelconque des revendications 1 à 10 caractérisé en ce que l'étape de mise en place de la pellicule de métal (102) s'effectue par évaporation sous bombardement électronique dans une enceinte dans laquelle un vide poussé a été réalisé et dépôt sur le support (100).

12. Procédé selon l'une quelconque des revendications 1 à 11 caractérisé en ce que le métal choisi étant du platine, la couche de platine (102) est transformée à la fin de la première étape en siliciure de platine par recuit sous hydrogène moléculaire ou bombardement ionique de gaz rare.

13. Procédé selon l'une quelconque des revendications 1 à 11 caractérisé en ce que le métal choisi étant du platine, la couche de silicium amorphe (101) est transformée en siliciure de platine au moins dans des zones prédéterminées de sa surface, par implantation ionique de platine superficielle.

14. Dispositif électronique (10) caractérisé en ce qu'il comprend au moins une couche de silicium amorphe (101) obtenue par le procédé selon l'une quelconque des revendications 1 à 13.

15. Dispositif selon la revendication 14 caractérisé en ce que ce dispositif est un dispositif de conversion de l'énergie solaire dans lequel la pellicule de métal (102) disposée sur la couche de silicium amorphe (101) constitue avec celle-ci une jonction de type Schottky.

**Claims**

1. A process of making a laser of hydrogencontaining amorphous silicon (101) including a step of depositing said layer of amorphous silicon on a support (100), characterized by comprising the following sequence of steps :

a) applying a metal skin (102) onto said layer of amorphous silicon (101), the metal being selected from the group comprising those having a high affinity to atomic hydrogen, and said metal skin having a thickness of at least 0.5 nm ;

b) hydrogenating said metal skin (102) ;

c) performing a thermal treatment between 100 °C and the crystallization temperature of the silicon, said treatment resulting in the diffusion of hydrogen from said metal skin, which then acts as a source of atomic hydrogen, into said layer of amorphous silicon.

2. A process as claimed in claim 1, characterized in that the step of hydrogenating said metal skin (102) is performed by exposing said metal skin for a predetermined time to an atmosphere of molecular hydrogen.

3. A process as claimed in claim 1, characterized in that the step of hydrogenating said metal skin (102) is performed by electrolysis in an acid solution (22).

4. A process as claimed in claim 3, characterized in that said acid solution (22) is a solution of dilute sulphuric acid.

5. A process of making a layer of hydrogencontaining amorphous silicon (101) including a step of depositing said layer of amorphous silicon on a support (100), characterized in that additionally it comprises the following sequence of steps :

a) applying a metal skin (102) on said layer of amorphous silicon (101), the metal being selected from the group comprising those having a high affinity to atomic hydrogen and said metal skin having a minimum thickness of 0.5 nm and a maximum thickness of less than 100 nm ;

b) exposing said metal skin (102) to a plasma of hydrogen or one of its isotopes and subjecting it to a thermal treatment at a temperature of between 100 °C and the crystallization temperature of silicon, whereby hydrogen diffuses from the plasma into the amorphous silicon.

6. A process as claimed in claim 5, characterized in that said thermal treatment and said treatment of said metal skin (102) with a hydrogen plasma are performed in an atmosphere containing hydrogen at a pressure in the range of 100 Pa and at a temperature in the range of 450 °C.

7. A process as claimed in any of the claims 5 or 6, characterized in that additionally during said first step said metal skin is applied non-uniformly onto the layer of amorphous silicon (101), the thickness of said metal skin (102) being varied in accordance with a predetermined programme, thereby dividing the surface of said layer of amorphous silicon (101) into at least two discrete zones.

8. A process as claimed in claim 7, characterized in that the surface of said layer of amorphous silicon (101) comprises at least three discrete zones, and that no metal is deposited on the first zone, the thickness e of the metal on the second zone is in the range of $0.5 \text{ nm} \leqslant e \leqslant 10 \text{ nm}$, and the metal on the third zone has a thickness e of more than 100 nm

9. A process as claimed in any of the claims 1 to 6, characterized in that the thickness e of said metal skin (102) is in the range of $0.5 \text{ nm} \leqslant e \leqslant 10 \text{ nm}$, and that said metal skin has a constant thickness and covers the entire surface of said layer of amorphous silicon (101).

10. A process as claimed in any of the claims 1 to 9, characterized in that the metal is selected from the group comprising the following metals : palladium, platinum, nickel, and iron.

11. A process as claimed in any of the claims 1 to 10, characterized in that said step of applying said metal skin (102) is performed by evaporation under electron bombardment in a high-vacuum chamber, and deposition on said support (100).

12. A process as claimed in any of the claims 1 to 11, characterized in that said selected metal is platinum, and that the platinum skin (102) at the termination of the first step is transformed to platinum silicide by heating under molecular hydrogen or ion bombardment with a rare gas.

13. A process as claimed in any of the claims 1 to 11, characterized in that said selected metal is platinum, and said layer of amorphous silicon (101) is transformed to platinum silicide at least in predetermined surface zones by superficial platinum ion implantation.

14. An electronic circuit device (10), characterized in that it comprises at least one layer of amorphous silicon (101) obtained in accordance with the process as claimed in any of the claims 1 to 13.

15. A circuit device as claimed in claim 14, characterized in that it constitutes a device for solar energy conversion, in which said metal skin (102) disposed on said layer of amorphous silicon (101) forms a Schottky-junction therewith.

**Ansprüche**

1. Verfahren zur Herstellung einer Schicht aus wasserstoffhaltigem amorphem Silicium (101), welches eine Stufe der Abscheidung der Schicht von amorphem Silicium auf einem Träger (100) aufweist, dadurch gekennzeichnet, daß es die nachstehenden aufeinander folgenden Stufen aufweist :

a) Aufbringen einer Metallhaut (102) auf die Schicht aus amorphem Silicium (101), wobei das Metall aus solchen ausgewählt ist, die eine große Affinität für atomaren Wasserstoff aufweisen, und die Metalhaut eine Mindestdicke von 0,5 nm hat ;

b) Hydrierung der Metallhaut (102) ;

c) Wärmebehandlung zwischen 100 °C und der Kristallisationstemperatur des Siliciums, welche dazu führt, daß Wasserstoff aus der dann als Quelle von atomarem Wasserstoff wirkenden Metallhaut in die Schicht aus amorphem Silicium diffundiert.

2. Verfahren nach Anspruch 1, dadurch gekennzeichnet, daß die Stufe der Hydrierung der Metallhaut (102) durchgeführt wird, indem man diese während einer bestimmten Zeit einer aus molekularem Wasserstoff bestehenden Atmosphäre aussetzt.

3. Verfahren nach Anspruch 1, dadurch gekennzeichnet, daß die Stufe der Hydrierung der Metallhaut (102) durch Elektrolyse in einer sauren Lösung (22) durchgeführt wird.

4. Verfahren nach Anspruch 3, dadurch gekennzeichnet, daß die saure Lösung (22) eine Lösung von verdünnter Schwefelsäure ist.

5. Verfahren zur Herstellung einer Schicht aus wasserstoffhaltigem amorphem Silicium (101), welches eine Stufe der Abscheidung der Schicht von amorphem Silicium auf einem Träger (100) aufweist, dadurch gekennzeichnet, daß es außerdem die nachstehenden aufeinander folgenden Stufen aufweist :

a) Aufbringen einer Metallhaut (102) auf die Schicht aus amorphem Silicium (101), wobei das Metall aus solchen ausgewählt ist, die eine große Affinität für atomaren Wasserstoff aufweisen, und wobei die Metallhaut eine Mindestdicke von 0,5 nm und eine Höchstdicke unter 100 nm hat ;

b) Die Metallschicht (102) wird einem Plasma von Wasserstoff oder einem seiner Isotopen ausgesetzt und einer Wärmebehandlung bei einer Temperatur zwischen 100 °C und der Kristallisationstemperatur des Siliciums unterworfen, wodurch vom Plasma kommender Wasserstoff in das amorphe Silicium diffundiert.

6. Verfahren nach Anspruch 5, dadurch gekennzeichnet, daß die Stufe der Wärmebehandlung und der Behandlung der Metallhaut (102) mit einem Wasserstoffplasma in einer Atmosphäre, welche Wasserstoff unter einem Druck in der Größenordnung von 100 Pa enthält, und bei einer Temperatur in der Größenordnung von 450 °C durchgeführt wird.

7. Verfahren nach einem der Ansprüche 5 oder 6, dadurch gekennzeichnet, daß außerdem während der ersten Stufe die Metallhaut in nicht gleichmäßiger Form auf die Schicht von amorphem Silicium (101) aufgebracht wird, wobei die Dicke der Metallhaut (102) gemäß einem vorbestimmten Programm verändert ist, wodurch die Oberfläche der Schicht aus amorphem Silicium (101) in mindestens zwei gesonderte Zonen unterteilt wird.

8. Verfahren nach Anspruch 7, dadurch gekennzeichnet, daß die Oberfläche der Schicht des amorphen Siliciums (101) mindestens drei gesonderte Zonen aufweist und daß auf der ersten Zone keinerlei Metall abgeschieden wurde, auf der zweiten Zone die Dicke e des Metalls im Bereich 0,5 nm ≤ e ≤ 10 nm liegt und auf der dritten Zone das Metall eine Dicke e über 100 nm hat.

9. Verfahren nach einem der Ansprüche 1 bis 6, dadurch gekennzeichnet, daß die Dicke e der Metallhaut (102) im Bereich 0,5 nm ≤ e ≤ 10 nm liegt und daß diese Metallhaut eine gleichbleibende Dicke hat und die gesamte Oberfläche der Schicht des amorphen Siliciums (101) bedeckt.

10. Verfahren nach einem der Ansprüche 1 bis 9, dadurch gekennzeichnet, daß das Metall ausgewählt ist aus den folgenden Metallen : Palladium, Platin, Nickel oder Eisen.

11. Verfahren nach einem der Ansprüche 1 bis 10, dadurch gekennzeichnet, daß die Stufe des Aufbringens der Metallhaut (102) durchgeführt wird durch Verdampfung unter Elektronenbeschuß in einer Kammer, in der ein Hochvakuum erzeugt wurde, und Abscheidung auf dem Träger (100).

12. Verfahren nach einem der Ansprüche 1 bis 11, dadurch gekennzeichnet, daß das ausgewählte Metall Platin ist und daß die Platinschicht (102) am Ende der ersten Stufe durch Erhitzen unter molekularem Wasserstoff oder Ionenbeschuß mit Edelgas in Platinsilicid umgewandelt ist.

13. Verfahren nach einem der Ansprüche 1 bis 11, dadurch gekennzeichnet, daß das ausgewählte Metall Platin ist und die Schicht aus amorphem Silicium (101) mindestens in vorbestimmten Zonen ihrer Oberfläche durch oberflächliche Ionenimplantation von Platin in Platinsilicid umgewandelt wird.

14. Elektronische Schaltanordnung (10), dadurch gekennzeichnet, daß sie mindestens eine Schicht von amorphem Silicium (101) aufweist, die nach dem Verfahren eines der Ansprüche 1 bis 13 erhalten wurde.

15. Schaltanordnung nach Anspruch 14, dadurch gekennzeichnet, daß sie eine Anordnung zur Umwandlung von Sonnenenergie ist, in der die auf der Schicht von amorphem Silicium (101) angeordnete Metallhaut (102) mit dieser einen Übergang vom Typ Schottky-Übergang bildet.

# FIG.1

# FIG.2

# FIG.3

# FIG.4